# EUROPEAN PATENT SPECIFICATION

(11) **EP 4 473 326 B1**
(45) Date of publication and mention of the grant of the patent: **25.11.2026**
(21) Application number: 23701966.6
(22) Date of filing: 26.01.2023
(51) Int. Cl.: G01R 33/00, G01R 33/20, G01R 33/26, G01R 33/032

(54) **SENSOR ASSEMBLY COMPRISING A MOUNTING SUPPORT FOR A DIAMOND**
SENSORANORDNUNG MIT EINER HALTERUNG FÜR EINEN DIAMANTEN
ENSEMBLE CAPTEUR COMPRENANT UN SUPPORT DE MONTAGE POUR UN DIAMANT

(30) Priority: 03.02.2022 EP 22305121
(43) Date of publication of application: 11.12.2024
(73) Proprietor: Kwan-Tek, 56270 Ploemeur (FR)
(72) Inventor: BEATO, François, 56100 Lorient (FR); ROUSSEL, Baptiste, 56100 Lorient (FR); HINGANT, Thomas, 35000 Rennes (FR)
(74) Representative: Yes My Patent
(86) International application number: PCT/EP2023/051931
(87) International publication number: WO 2023/148081

(56) References cited:
- EP-A1- 3 851 863
- CN-A- 105 352 489
- CN-A- 111 504 499
- DE-A1- 102018 208 055
- SERGEI MASIS ET AL: "Optically detected flip-flops between different spin ensembles in diamond", ARXIV.ORG, CORNELL UNIVERSITY LIBRARY, 201 OLIN LIBRARY CORNELL UNIVERSITY ITHACA, NY 14853, 16 March 2021 (2021-03-16), XP081911213

## Description

### TECHNICAL FIELD

A sensor assembly comprising a nitrogen-vacancy diamond forming a source of fluorescence coupled to a fluorescence collector is described. A magnetometer comprising the sensor assembly is also described.

### BACKGROUND

Magnetometers based on the probing of the energy level differences in Nitrogen Vacancy (NV) color centers in diamonds are a promising technology, for example for magnetic field stabilization. In such case, the NV magnetometer is used to measure the fluctuations of a supposedly constant, or slowly varying magnetic field, in order to compensate these fluctuations. In order to be able to measure efficiently fields with high intensities (>30 mT), the NV center has to be aligned with the field to measure. Using a fiber is important to access regions where space is constrained, like in the case of atomic physics experiments, where several lasers address the same atomic cloud (where the field needs to be controlled). Hence, a small and deported sensor is desirable

It has been proposed to use an optical fiber to excite an NV diamond crystal and to collect the resulting fluorescence, like in the document DE102018208055A1. Indeed, coupling diamonds with NV centers to fibers can make them good candidates for performing magnetometry in challenging environments. An NV-based magnetometer in which an optical fiber is used is described by Chatzidrosos, Georgios, et al. "Fiberized Diamond-Based Vector Magnetometers." Frontiers in Photonics, 2021.

In order to align the magnetic field with the NV axis in, the lack of references imposes to use adjustable angular mounts, such as tip-tilt platforms. While good alignment can be achieved with this, a mechanical alignment requires a calibration and complex mechanics that can be prone to drifts in time, for example if a spring-loaded mount loosens or is subjected to vibrations. Ideally, a bulk sensor is desirable.

An alternative is to use diamonds with one facet perpendicular to a (111) diagonal. This is for example used in the work of Hatano et al. (Appl. Phys. Lett. 118, 034001 (2021)). However, this leads to costly and hard to manufacture diamonds.

It is therefore desirable to provide a sensor assembly allowing to use standard diamond where the cut facets correspond to the {100} planes.

### SUMMARY

The scope of protection is set out by the claims.

A first aspect concerns a sensor assembly comprising:
- a nitrogen-vacancy diamond,
- an optical fiber which front end is connected to a top main surface of the nitrogen-vacancy diamond,
- a micro-wave cable which front end is connected to the nitrogen-vacancy diamond,
- a mounting support,
characterized in that the mounting support comprises a support element having a bottom surface defining a reference plane, and having, at a front end, a socket designed to receive the nitrogen-vacancy diamond in a predetermined angular position around 54.7 or 125.3 degrees +/- 5 degrees with regards to the reference plane allowing predetermined alignment of its nitrogen-vacancy axis with regards to the reference plane, said socket comprising a recess for housing said nitrogen-vacancy diamond in the predetermined angular position.

According to an embodiment, the recess comprises peripheral retaining surfaces for the diamond which form predetermined angles such that, when the nitrogen-vacancy diamond is received in the recess, a diagonal extending from a diamond top corner to a diamond bottom corner is within a longitudinal plane perpendicular to the reference plane.

According to an embodiment, the recess comprises an extruded platform which forms a bearing surface for a main surface of the nitrogen-vacancy diamond, said platform being elevated compared to a recess bottom portion.

According to an embodiment, the bearing surface is tilted, with regards to the reference plane, of an angle around 54.7 degrees or 125.3 degrees +/- 5 degrees.

According to an embodiment, the mounting support comprises a holder element on the support element, and which comprises a guiding surface to guide and bend the optical fiber from the nitrogen-vacancy diamond to a rear portion of the holder element, said optical fiber having a front section received in the holder element.

According to an embodiment, the guiding surface is arranged on a front portion of the holder element, close to the socket, said guiding surface comprising a groove having an arc shaped profile within a longitudinal plane perpendicular to the reference plane.

According to an embodiment, the groove is designed such that a tangent to the arc shaped profile at a groove front end is perpendicular to a diamond main surface which receives a front end of the optical fiber.

According to an embodiment, the rear portion of the holder element comprises a channel part which extends from the front portion to a rear end of the holder element, and which is designed to hold at least a section of the optical fiber.

According to an embodiment, the recess is arranged in a socket sloped surface defining a slope angle corresponding to the predetermined angular position.

According to an embodiment, the holder element front portion comprises a holder element sloped surface which is complementary to the socket sloped surface and which comes in abutment against the socket sloped surface when the nitrogen-vacancy diamond is in position inside the recess.

According to an embodiment, the support element comprises an elongated portion forming a guiding rail for the holder element to allow the holder element to slide from a rear position away from the socket to a front position in abutment against the socket.

According to an embodiment, the sensor assembly comprises a top cover which is arranged above the socket to enclose the nitrogen-vacancy diamond and the optical fiber.

According to an embodiment, the socket is made of one piece with the support element.

According to an embodiment, the nitrogen-vacancy diamond is a monocrystalline face-centered cubic diamond, the cut facets of the nitrogen-vacancy diamond corresponding to the {100} planes such that a nitrogen-vacancy axis within the nitrogen-vacancy diamond is perpendicular to the reference plane when it is mounted in the socket.

Another aspect of the invention relates to a magnetometer comprising a sensor assembly according to any of the preceding embodiments.

### BRIEF DESCRIPTION OF THE DRAWINGS

Example embodiments will be more fully understood from the detailed description provided herein and the accompanying drawings, which are given by way of illustration only.
FIG.1 is a schematic representation of a diamond crystal and its carbon atoms (C), and comprising a nitrogen atom (N) and a vacancy (V), the latter two forming an 'NV center';
FIG.2 is a schematic diagram of the energy levels of an NV center;
FIG.3 is a graph of ODMR (Optically Detected Magnetic Resonance) data obtained by measuring the red fluorescence for different magnetic field values;
FIG.4 is a schematic representation of a diamond crystal and its carbon atoms for all four orientations of the NV center;
FIG.5 is a schematic representation of a diamond crystal showing the angle of the NV axis with respect to the diamond axes;
FIG.6 is a graph showing evolution of the position of the ODMR lines with different magnetic field angles, the vertical axis showing the frequency and the horizontal axis showing the magnetic field;
FIG.7 is a chart plotting the evolution of the contrast of ODMR spectra with increasing the magnetic field with an angle of θ=74° with the NV axis;
FIG.8 is a schematic representation showing the alignment of the NV center of the NV diamond with the magnetic field to be measured;
FIG.9 is an exploded perspective view showing a sensor assembly according to a non-limiting exemplary embodiment comprising a socket for a NV diamond;
FIG. 10 is a perspective view of a front portion of the sensor assembly of FIG.9 with a top cover removed and a holder element in a front position in abutment against the socket;
FIG.11 is a cross-section view according to section plane XI-XI of FIG. 10 showing the sensor assembly of FIG.9;
FIG.12 is a perspective view of the front portion of the sensor assembly as in FIG. 10 with the holder element in a rear position;
FIG.13 is a rear view showing the socket before the NV diamond is mounted in a recess and illustrating the orientation of the recess;
FIG.14 is a schematic representation showing a magnetometer equipped with the sensor assembly of FIG.9.

It should be noted that these figures are intended to illustrate the general characteristics of methods, structure and/or materials utilized in the described exemplary embodiments. The drawings are not to scale and should not be interpreted as limiting the range of values or properties encompassed by the exemplary embodiments.

### DETAILED DESCRIPTION

Various exemplary embodiments will now be described more fully with reference to the accompanying drawings. However, specific structural and functional details disclosed herein are merely representative for purposes of describing example embodiments. The exemplary embodiments may be embodied in many alternate forms and should not be construed as limited to only the embodiments set forth herein. It should be understood that there is no intent to limit example embodiments to the particular forms disclosed.

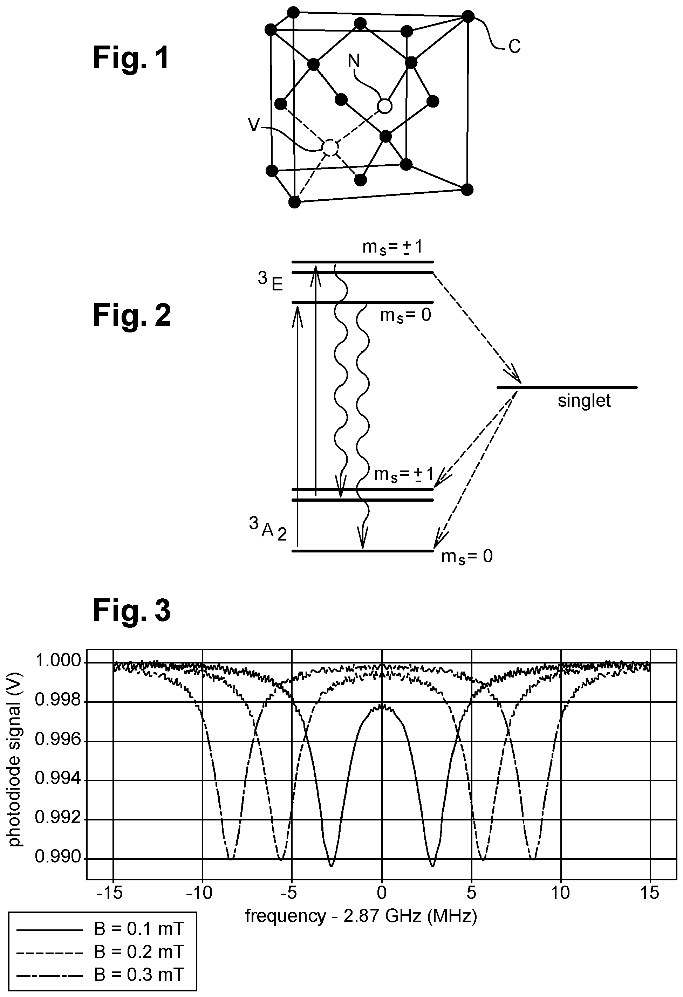

NV magnetometry is based on the use of a particular defect of the diamond crystal lattice in the solid state. The term NV (Nitrogen-Vacancy) center refers to the substitution of a carbon atom by a nitrogen atom, directly adjacent to a lattice vacancy (a missing carbon atom), as shown in FIG.1. This defect presents energy levels and various interesting physical characteristics, which can be used in a magnetic field sensor. These measurements can also be used to determine temperatures, electric fields, strains and pressure. In particular, when a NV diamond crystal (containing millions of NV centers) is irradiated with green light (e.g. coming from a laser or a LED), it fluoresces red light with an intensity generally proportional to the irradiation.

FIG.2 is a schematic diagram of the energy levels of the NV center, and showing the ground state triplet state ³A₂, the excited triplet state ³E and the singlet state. Owing to quantum mechanical selection rules, when the NV center is in the ms = 0, respectively ms = ± 1 state, in the ground state, it tends to stay in the ms = 0, respectively ms = ± 1, state when absorbing a green photon from the excitation light source, as shown by the two upward oriented straight arrows. Similar selection rules apply when the NV center is de-excited from the excited state to the ground state by the emission of a red fluorescence photon, as shown by the two downward oriented wobbly arrows. However, when the NV center lands in the ms = ± 1 levels in the excited state, it has a larger (about 7 times) probability to decay non radiatively in the singlet state than when in the ms = 0 excited state. From the singlet state, the NV center returns preferentially (with twice larger probability) to the ms = 0 ground state. As a result, the NV center can be optically polarized in the ms = 0 ground state through the application of green excitation light. Red fluorescence is emitted owing to the radiative decay from the excited state to the ground state. This level of fluorescence varies depending on the initial spin level of the NV center in the ground state: more fluorescence is recorded when the NV center is initially in the ms = 0 spin level than in the ms = ± 1 levels, owing to the non-radiative transitions through the singlet state in the second case.

A microwave field with a frequency around 2.87 GHz can be applied to change the spin state of the NV center in its ground state from ms = 0 to ms = 1 or ms = -1. When the frequency of the microwave field is resonant with the energy level difference, the spin state is changed and less red fluorescence is observed. This phenomenon is called Optically Detected Magnetic Resonance ('ODMR').

A magnetic field lifts the degeneracy between the ms = 1 and ms = -1 levels. Therefore, when a magnetic field is applied to the NV center, two frequencies for which the fluorescence decreases can be observed. In a first approach, one can consider that the two frequencies are linearly related to the magnitude of the magnetic field: ${f}_{res} = 2.87 GHz \pm \frac{γ}{2 π} B$ (Eq. 1)
where B is the magnetic field aligned with the axis of the NV center (i.e. the axis defined by the alignment of the nitrogen atom and the gap) and γ is the gyromagnetic ratio of the NV center: *γ* / 2*π*=28 GHz/T.

FIG.3 is a graph of simulated ODMR data that can be obtained by measuring the red fluorescence for different magnetic field values. For each value of the magnetic field, the two resonance dips in the photodiode output signal and centered around the excitation frequency appear clearly. The spacing of the dips increases with the intensity of the magnetic field. Since the NV centers can exist in four different directions within the crystal, a total of four pairs of two resonances can actually be observed, each pair corresponding to a projection of the magnetic field vector onto a given direction of an NV axis. This allows to univocally identify the three spatial components of the magnetic field, and thus to obtain a vector measurement of the latter. The NV sensor allows an accurate vector measurement of a magnetic field, with a good sensitivity: the latter is often limited by the photon shot noise of the fluorescence light, reaching typical values ranging from pT/ √ Hz to nT/ √ Hz depending on the sensor design.

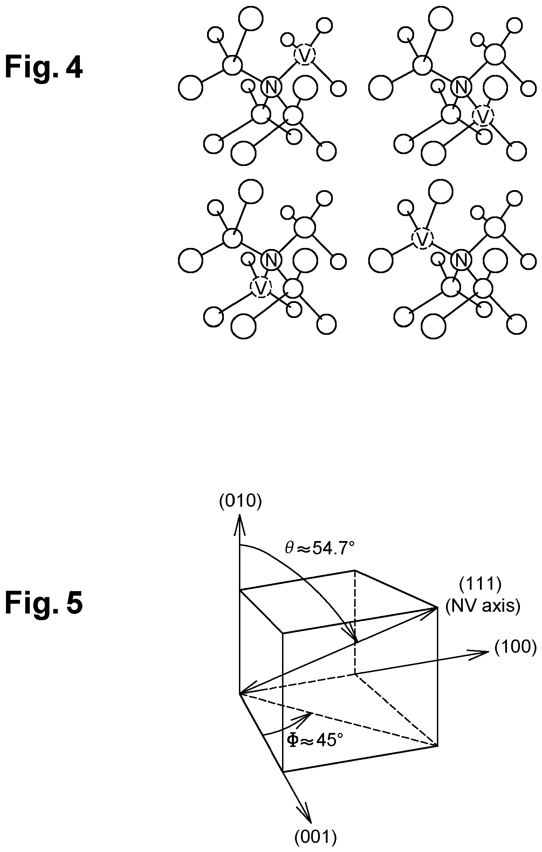

The NV axis is defined by the direction which links the nitrogen atom to the vacancy. In a monocrystalline face-centered cubic diamond, the NV center exists in four possible orientations, which correspond to the four possible positions of the vacancy when the nitrogen atom is given, as shown on FIG.4. These directions are actually defined by the (111) diagonals of the diamond cubic matrix. In most diamonds, the cut facets correspond to the {100} planes, which means that the NV axes are oriented away from the surfaces with angles θ=arctan( √ 2)≈54.7° while ϕ=45°, as shown on FIG.5.

Fabricating diamonds with different orientations, for example so that one facet is perpendicular with a (111) diagonal is possible but very difficult, and doping levels in NV centers are lower than for diamonds like described in FIG.5.

By applying a microwave field to the NV center, while recording the red photoluminescence, it is possible to perform an optical detection of a magnetic resonance (ODMR). When the frequency of the microwave is scanned around 2.8 GHz, reduction of photoluminescence is observed when the frequency matches the energy difference between the spin states with ms = 0 and ms = ±1. It is thus possible to measure the energy difference between the different spin states. In the presence of an external magnetic field, the energy of the ms = -1 and ms = +1 states changes due to the Zeeman effect. The NV center is therefore intrinsically an atomic-sized magnetometer. With diamonds highly doped in NV centers, one can improve the sensitivity and the resolution becomes limited by the size of the sensor. The diamond can then be attached to a fiber and a microwave cable to fabricate a fibered magnetometer, for example like in the work of Hatano et al. (Appl. Phys. Lett. 118, 034001 (2021)).

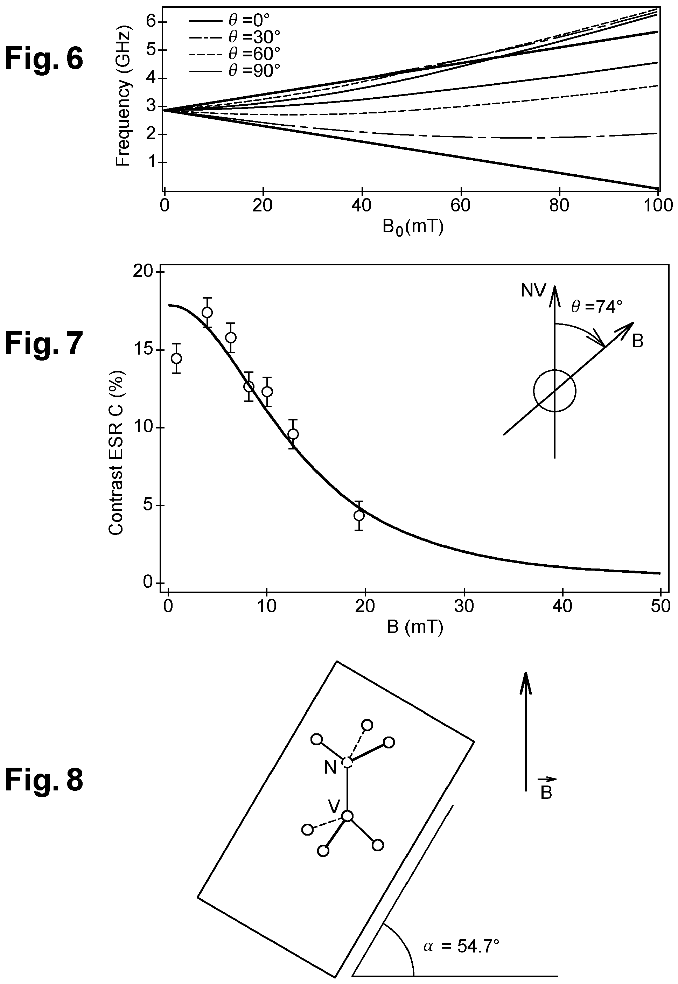

FIG.6 and FIG.7 illustrate the influence of the angle between the magnetic field and the NV axis. These figures are extracted from the thesis report 'Réalisation d'un magnétomètre à centre coloré NV du diamant' Autre [cond-mat.other]. École normale supérieure de Cachan - ENS Cachan, 2012. Français. NNT : 2012DENS0065. tel-00824468. When the magnetic field to measure has a strong component orthogonal to the NV axis, the position of the lines evolves with the response is non-linear and can be mistaken for a temperature change. This non-linearity is described in FIG.6 for different orientations θ of the magnetic field with respect to the NV axis.

Additionally, the contrast of the ODMR signal decreases when a strong off-axis magnetic field is applied, and the measurement is degraded. This is illustrated in FIG.7 which display the evolution of the contrast of ODMR spectra with increasing the magnetic field with an angle of θ=74° with the NV axis. If the magnetic field is to be measured in a robust fashion, it is therefore desirable to align the NV axis with the measurement axis which is parallel to the direction of the magnetic field to be measured. In the notation above it means θ = 0° or 180°.

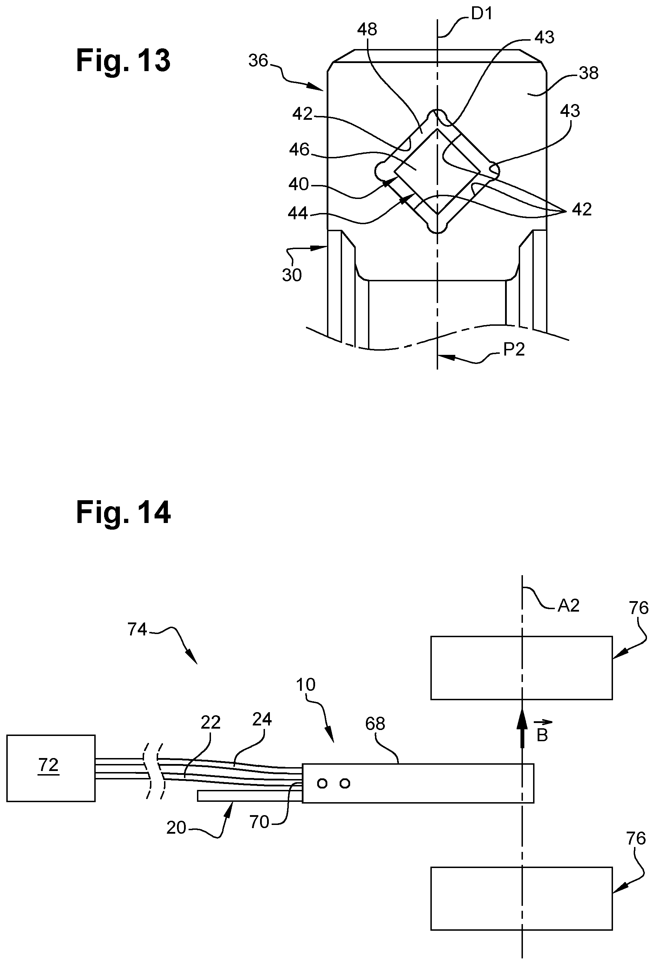

On FIG.8 is shown schematically the position required for the NV diamond with the NV axis parallel with the magnetic field B to be measured. It can be seen that the angle between a reference plane perpendicular to the magnetic field direction and a main surface of the NV diamond is equal to 54.7 degrees. A second rotation is performed around a normal to the main face of the NV diamond, and is such that the normal to a lateral face, or side facet, is oriented at 45° with respect to a normal to the plane containing the magnetic field axis B and a normal to the main face. This will become apparent on figure 13.

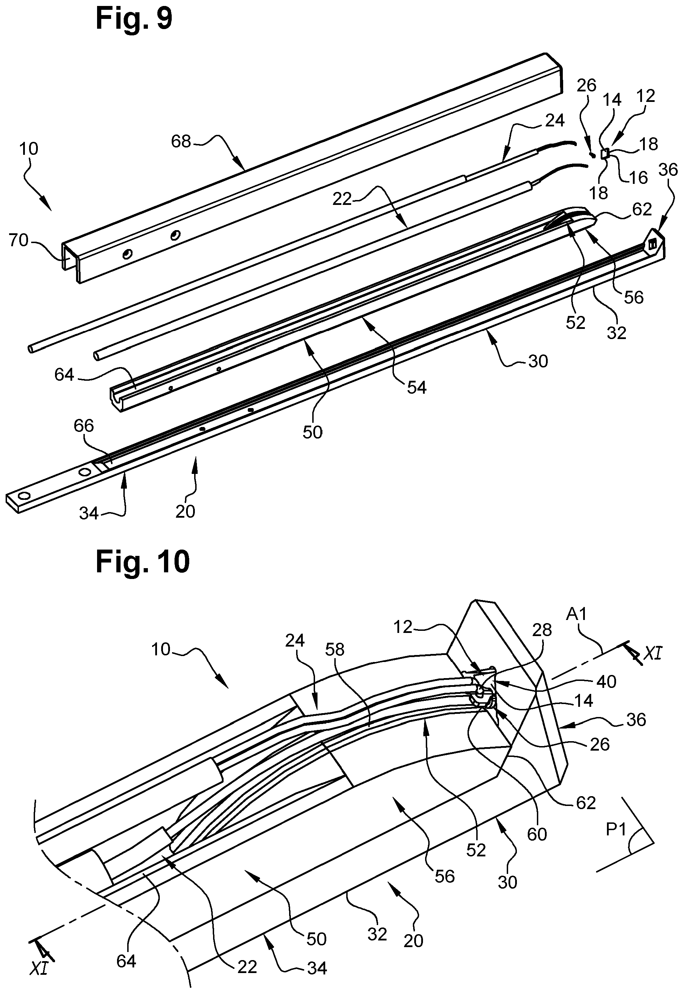

FIG.9 to FIG.13 show a sensor assembly 10 according to an embodiment of the invention allowing alignment of the NV axis with the measurement axis. The sensor assembly 10 comprises a NV diamond 12 of standard type which means a diamond where the cut facets correspond to the {100} planes.

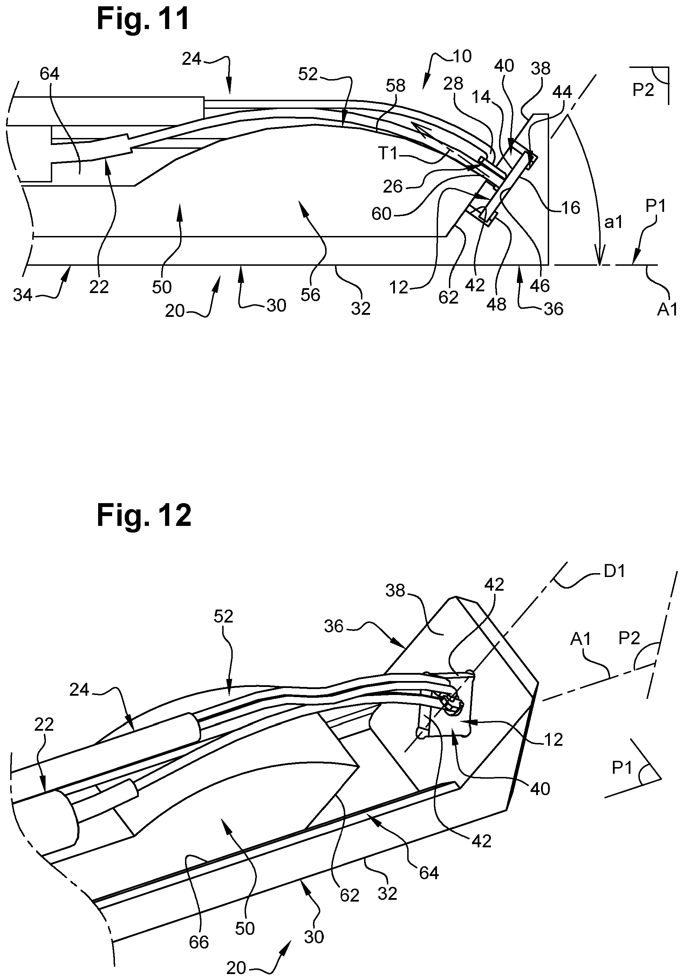

As can be seen on FIG.9 and FIG. 11, the NV diamond 12 has a general parallelepipedic shape comprising a top main surface 14, a bottom main surface 16, and four side facets 18. The top and bottom main surfaces 14, 16 are square surfaces.

The sensor assembly 10 comprises a mounting support 20 which is designed to receive the NV diamond 12 with at least one optical fiber 22 and two microwave cables 24. The optical fiber 22 has its free end connected to the NV diamond 12, for example by gluing to the top main surface 14.

According to the embodiment shown, the microwave cables 24 are constituted of two coaxial cables which bring the micro-wave excitation to the extremity of the sensor assembly 10. There are several possibilities to generate the microwave magnetic field that excites the NVs. The simplest way is to connect a shorted wire between the core and the sheath of the coaxial cables. The wire can be coiled to increase the field strength.

In the present embodiment, two wires 28 are connected to the sheath and core of each coaxial cable, and soldered at their other end to a mounting bracket 26. The mounting bracket 26 is made of a small bent copper antenna that encircles the optical fiber 22 and that serves as a short circuit. The mounting bracket 26 can be glued to the top main surface 14 of the NV diamond 12.

In an alternative embodiment (not shown), a coaxial connector could be used and soldered directly to a copper patch used to make the short circuit. The coaxial cable is connected to the short circuit via the connector. Another option is to use a microwave resonator (cavity, resonator circuit, etc.), which is only connected to the core of the coaxial cable. In this case there is no short circuit.

The mounting support 20 comprises a support element 30 having a bottom surface 32 defining a reference plane P1. Said support element 30 is formed of an elongated plate member 34 extending along a longitudinal axis A1 and having, at a front end, a socket 36 designed to receive the NV diamond 12 in a predetermined angular position a1 different from zero or 90 degrees, preferably of 54.7 degrees, allowing predetermined alignment of the NV axis with regards to the reference plane P1.

In the following description, an orientation along the longitudinal axis A1 will be used without any limitation purpose, for the sake of better understanding. Said longitudinal axis A1 is orientated from front to rear which corresponds to an orientation from right to left when considering FIG.10 or FIG.11.

The socket 36 comprises a rear facing sloped surface 38 which is inclined preferably at the same angle a1 as the NV diamond 12 of 54.7 degrees with regards to the reference plane P1, as can be seen on FIG.11. A recess 40 for the NV diamond 12 is formed in the sloped surface 38, preferably by machining. The recess 40 comprises peripheral retaining surfaces 42 for the NV diamond 12 which form predetermined angles such that, when the NV diamond 12 is received in the recess 40, a diagonal D1 extending from a diamond top corner to a diamond bottom corner is within a longitudinal plane P2 perpendicular to the reference plane P1. With regards to the sloped surface 38 and its top and bottom edges, the recess 40 and its side edges are shifted from 45 degrees as illustrated on FIG.13. Preferably, each comer of the recess 40 comprises a semi-cylindrical surface 43 allowing for easier insertion of the NV diamond 12 in the recess 40 while still ensuring precise positioning of the NV diamond 12 while cooperating with the retaining surfaces 42.

The NV diamond 12 should be positioned as close as possible to the angle a1 of 54.7 degrees and the rear facing sloped surface 38 should define an angle a1 as close as possible to the angle of 54.7 degrees, preferably equal to 54.7 degrees. Alternatively, a slight angle deviation could work as well, for example +/- 5 degrees. The higher the magnetic field to be measured would be, the more accurate the angle a1 should be. Regarding the 45 degrees shift, the same would apply. It is important to be as close as possible to 45 degrees, preferably equal to 45 degrees, but a slight deviation would not prevent the sensor assembly to work as well. What is important is that the deviation should not deteriorate the measurement to a non-acceptable level.

Advantageously, the recess 40 comprises an extruded platform 44 which forms a bearing surface 46 for the bottom main surface 16 of the NV diamond 12. Said extruded platform 44 is elevated compared to a recess bottom portion 48 which ensure accurate positioning of the NV diamond 12 within the recess 40. The bearing surface 46 is tilted, with regards to the reference plane P1, of the same angle a1 of 54.7 degrees as for the sloped surface 38. The NV diamond 12 has a square surface, its bottom main surface 16, facing the extruded platform 44, so that the diagonal D1 represents 45 degrees.

Preferably, the support element 30 is made of one piece by machining, including the socket 36. In an alternative embodiment, the elongated support element 30 could be manufactured differently, for example by molding or additive manufacturing.

The mounting support 20 also comprises a holder element 50 which is mounted on the support element 30, and which comprises a guiding surface 52 to guide and bend the optical fiber 22 from the NV diamond 12 to a rear portion 54 of the holder element 50. The guiding surface 52 is arranged on a front portion 56 of the holder element 50, close to the socket 36. Said guiding surface 52 comprises a groove 58 having an arc shaped profile within the longitudinal plane P2. The groove 58 is designed such that a tangent T1 to the arc shaped profile at a groove front end 60 is perpendicular to the diamond top main surface 14.

According to an alternative embodiment (not shown), the holder element 50 could be made of one piece with the support element 30.

Advantageously the holder element front portion 56 comprises a holder element sloped surface 62 which is complementary to the socket sloped surface 38 and which comes in abutment against the socket sloped surface 38 when the NV diamond 12 is received inside the recess 40.

The holder element rear portion 54 comprises a channel part 64 which extends from the holder element front portion 56 to a rear end of the holder element 50, and which is designed to hold a section of the optical fiber 22 and a section of the microwave cables 24. The channel part 64 is made as an elongated portion of the holder element 50 with a U-shaped cross section.

Advantageously the elongated plate member 34 includes a guiding portion forming a guiding rail 66 for the holder element 50 to allow the holder element 50 to slide along the guiding rail 66 from a rear position away from the socket 36, which is shown on FIG.12, to a front position in abutment against the socket 36, as shown on FIG.10 and FIG.11. The guiding rail 66 has a cross-section at least partly complementary to the cross-section of the holder element 50 in order to allow the holder element 50 to slide in the guiding rail 66.

Advantageously, the mounting support 20 also comprises a top cover 68 which is mounted on the support element 30 above the holder element 50 and above the socket 36 to enclose the NV diamond 12, the optical fiber 22, and the microwave cables 24.

An assembly method will now be described. The optical fiber 22 and the microwave cables 24 are attached to the NV diamond top main surface 14 with the mounting bracket 26 by gluing or any other suitable means. Then the NV diamond 12 is inserted into the recess 40 until its bottom main surface 16 bears against the bearing surface 46. The NV diamond 12 is maintained in its predetermined position thanks to the retaining surfaces 42 and the bearing surface 46. Glue is also injected into the recess 40 on top of the NV diamond 12 to entirely seal it and secure its position together with the optical fiber 22 and microwave cables 24 free ends.

Then the holder element 50 is slid from its rear position, shown on FIG.12, to its front position, shown on FIG.10 and FIG.11, along the guiding rail 66. The top cover 68 is then assembled to the support element 30, for example with screw mount. The mounting support 20 still has a rear opening 70 through which the optical fiber 20 and the microwave cables 24 extends to be connected to a control unit 72 forming part of a magnetometer 74 shown on FIG.14.

As an exemplary embodiment shown on FIG. 14, the magnetometer 74 implements the sensor assembly 10 according to the invention to measure the magnetic field B generated between two coils 76 along a vertical axis A2 corresponding to the NV axis of the NV diamond 12 forming part of the sensor assembly 10.

Advantageously, the mounting support 20 is designed to be rather long in comparison with the size of the NV diamond 12 because this kind of sensor is usually used in places difficult to reach with a classic setup. It is why the sensor assembly 10 has a long length but small width and height. It is therefore important to have a long and narrow mounting support 20 that can be easily manipulated.

The sensor assembly 10 is particularly useful when implemented in a high field stabilization scheme but it can be derived to any usage of a NV magnetometer 74 with bulk diamonds.

Although the embodiment described in connection with the figures relates to an NV diamond 12 in a predetermined angular position having an angle a1 of 54.7 degrees allowing alignment of the NV axis with regards to the reference plane P1 along a perpendicular direction to the reference plane P1, i.e. parallel to the magnetic field axis B, other embodiments would work as well with for example an angle a1 of 125.3 degrees.

Alternatively, the angular position of the NV diamond 12 in the mounting support 20 could be equal to respectively 135 degrees, 225 degrees, or 315 degrees while still allowing proper measurement along an axis perpendicular to the reference plane P1, whether the angle a1 is of 54.7 degrees or 125.3 degrees.

### References to the Drawings

| | | | |
|---|---|---|---|
| 10 | Sensor assembly | 52 | guiding surface |
| 12 | NV diamond | 54 | holder element rear portion |
| 14 | diamond top main surface | 56 | holder element front portion |
| 16 | diamond bottom main surface | 58 | groove |
| 18 | side facets | 60 | groove front end |
| 20 | mounting support | 62 | holder element sloped surface |
| 22 | optical fiber | 64 | channel part |
| 24 | microwave cables | 66 | guiding rail |
| 26 | mounting bracket | 68 | top cover |
| 28 | wires | 70 | rear opening |
| 30 | support element | 72 | control unit |
| 32 | bottom surface | 74 | magnetometer |
| 34 | elongated plate member | 76 | coils |
| 36 | socket | a1 | angle between NV diamond and reference plane |
| 38 | socket sloped surface | | |
| 40 | recess | A1 | longitudinal axis |
| 42 | retaining surfaces | A2 | NV axis |
| 43 | semi-cylindrical surface | P1 | reference plane |
| 44 | extruded platform | P2 | longitudinal plane |
| 46 | bearing surface | T1 | tangent |
| 48 | recess bottom portion | | |
| 50 | holder element | | |

## Claims

1. Sensor assembly (10) comprising:
- a nitrogen-vacancy diamond (12),
- an optical fiber (22) which front end is connected to a top main surface (14) of the nitrogen-vacancy diamond (12),
- a micro-wave cable (24) which front end is connected to the nitrogen-vacancy diamond (12),
- a mounting support (20),
**characterized in that** the mounting support (20) comprises a support element (30) having a bottom surface (32) defining a reference plane (P1), and having, at a front end, a socket (36) designed to receive the nitrogen-vacancy diamond (12) in a predetermined angular position (a1) around 54.7 or 125.3 degrees +/- 5 degrees with regards to the reference plane (P1) allowing predetermined alignment of its nitrogen-vacancy axis with regards to said reference plane (P1), said socket (36) comprising a recess (40) for housing said nitrogen-vacancy diamond (12) in the predetermined angular position (a1).

2. Sensor assembly (10) according to claim 1, wherein the recess (40) comprises peripheral retaining surfaces (42) for the diamond which form predetermined angles such that, when the nitrogen-vacancy diamond (12) is received in the recess (40), a diagonal (D1) extending from a diamond top comer to a diamond bottom corner is within a longitudinal plane (P2) perpendicular to the reference plane (P1).

3. Sensor assembly (10) according to any of the preceding claims, wherein the recess (40) comprises an extruded platform (44) which forms a bearing surface (46) for a main surface (16) of the nitrogen-vacancy diamond (12), said platform (44) being elevated compared to a recess bottom portion (48).

4. Sensor assembly (10) according to the preceding claim, wherein the bearing surface (46) is tilted, with regards to the reference plane (P1), of an angle (a1) around 54.7 or 125.3 degrees +/- 5 degrees.

5. Sensor assembly (10) according to any of the preceding claims, wherein the mounting support (20) comprises a holder element (50) on the support element (30), and which comprises a guiding surface (52) to guide and bend the optical fiber (22) from the nitrogen-vacancy diamond (12) to a rear portion of the holder element (50), said optical fiber (22) having a front section received in the holder element (50).

6. Sensor assembly (10) according to the preceding claim, wherein the guiding surface (52) is arranged on a front portion of the holder element (50), close to the socket (36), said guiding surface (52) comprising a groove (58) having an arc shaped profile within a longitudinal plane (P2) perpendicular to the reference plane (P1).

7. Sensor assembly (10) according to the preceding claim, wherein the groove (58) is designed such that a tangent (T1) to the arc shaped profile at a groove front end (60) is perpendicular to a diamond main surface (14) which receives a front end of the optical fiber (22).

8. Sensor assembly (10) according to any one of claims 5 to 7, wherein the rear portion of the holder element (50) comprises a channel part (64) which extends from the front portion (56) to a rear end of the holder element (50), and which is designed to hold at least a section of the optical fiber (22).

9. Sensor assembly (10) according to any of the preceding claims, wherein the recess (40) is arranged in a socket sloped surface (38) defining a slope angle corresponding to the predetermined angular position (a1).

10. Sensor assembly (10) according to the preceding claim taken in combination with claims 5, wherein the holder element front portion (56) comprises a holder element sloped surface (62) which is complementary to the socket sloped surface (38) and which comes in abutment against the socket sloped surface (38) when the nitrogen-vacancy diamond (12) is in position inside the recess (40).

11. Sensor assembly (10) according to any of the preceding claims taken in combination with claim 5, wherein the support element (30) comprises an elongated portion forming a guiding rail (66) for the holder element (50) to allow the holder element (50) to slide from a rear position away from the socket (36) to a front position in abutment against the socket (36).

12. Sensor assembly (10) according to any of the preceding claims, wherein it comprises a top cover (68) which is arranged above the socket (36) to enclose the nitrogen-vacancy diamond (12) and the optical fiber (22).

13. Sensor assembly (10) according to any of the preceding claims, wherein the socket (36) is made of one piece with the support element (30).

14. Sensor assembly (10) according to any of the preceding claims, wherein the nitrogen-vacancy diamond (12) is a monocrystalline face-centered cubic diamond, the cut facets of the nitrogen-vacancy diamond (12) corresponding to the {100} planes such that a nitrogen-vacancy axis within the nitrogen-vacancy diamond (12) is perpendicular to the reference plane (P1) when it is mounted in the socket (36).

15. Magnetometer (74) comprising a sensor assembly (10) according to any of the preceding claims.

## Patentansprüche

1. Sensoranordnung (10), umfassend:
- einen Stickstoffleerstellendiamanten (12),
- eine optische Faser (22), deren vorderes Ende mit einer oberen Hauptoberfläche (14) des Stickstoffleerstellendiamanten (12) verbunden ist,
- ein Mikrowellenkabel (24), dessen vorderes Ende mit dem Stickstoffleerstellendiamanten (12) verbunden ist,
- einen Montageträger (20),
**dadurch gekennzeichnet, dass** der Montageträger (20) ein Trägerelement (30) umfasst, das eine untere Oberfläche (32) aufweist, die eine Referenzebene (P1) definiert, und an einem vorderen Ende eine Fassung (36) aufweist, die ausgelegt ist, um den Stickstoffleerstellendiamanten (12) in einer vorbestimmten Winkelposition (a1) von etwa 54,7 oder 125,3 Grad +/- 5 Grad in Bezug auf die Referenzebene (P1) aufzunehmen, was eine vorbestimmte Ausrichtung seiner Stickstoffleerstellenachse in Bezug auf die Referenzebene (P1) ermöglicht, die Fassung (36) umfassend eine Aussparung (40) zum Unterbringen des Stickstoffleerstellendiamanten (12) in der vorbestimmten Winkelposition (a1).

2. Sensoranordnung (10) nach Anspruch 1, wobei die Aussparung (40) periphere Rückhalteoberflächen (42) für den Diamanten umfasst, die vorbestimmte Winkel derart ausbilden, dass, wenn der Stickstoffleerstellendiamant (12) in der Aussparung (40) aufgenommen ist, eine Diagonale (D1), die sich von einer oberen Diamantecke zu einer unteren Diamantecke erstreckt, innerhalb einer Längsebene (P2) senkrecht zu der Referenzebene (P1) ist.

3. Sensoranordnung (10) nach einem der vorstehenden Ansprüche, wobei die Aussparung (40) eine extrudierte Plattform (44) umfasst, die eine Lageroberfläche (46) für eine Hauptoberfläche (16) des Stickstoffleerstellendiamanten (12) ausbildet, wobei die Plattform (44) im Vergleich zu einem unteren Aussparungsabschnitt (48) erhöht ist.

4. Sensoranordnung (10) nach dem vorstehenden Anspruch, wobei die Lageroberfläche (46) in Bezug auf die Referenzebene (P1) um einen Winkel (a1) von etwa 54,7 oder 125,3 Grad +/- 5 Grad geneigt ist.

5. Sensoranordnung (10) nach einem der vorstehenden Ansprüche, wobei der Montageträger (20) ein Halterungselement (50) auf dem Trägerelement (30) umfasst und das eine Führungsoberfläche (52) umfasst, um die optische Faser (22) von dem Stickstoffleerstellendiamanten (12) zu einem hinteren Abschnitt des Halterungselements (50) zu führen und zu biegen, wobei die optische Faser (22) einen vorderen Bereich aufweist, der in dem Halterungselement (50) aufgenommen ist.

6. Sensoranordnung (10) nach dem vorstehenden Anspruch, wobei die Führungsoberfläche (52) an einem vorderen Abschnitt des Halterungselements (50) nahe der Fassung (36) eingerichtet ist, die Führungsoberfläche (52) umfassend eine Nut (58), die ein bogenförmiges Profil innerhalb einer Längsebene (P2) senkrecht zu der Referenzebene (P1) aufweist.

7. Sensoranordnung (10) nach dem vorstehenden Anspruch, wobei die Nut (58) derart ausgelegt ist, dass eine Tangente (T1) an das bogenförmige Profil an einem vorderen Nutende (60) senkrecht zu einer Diamanthauptoberfläche (14) ist, die ein vorderes Ende der optischen Faser (22) aufnimmt.

8. Sensoranordnung (10) nach einem der Ansprüche 5 bis 7, wobei der hintere Abschnitt des Halterungselements (50) ein Kanalteil (64) umfasst, das sich von dem vorderen Abschnitt (56) zu einem hinteren Ende des Halterungselements (50) erstreckt und das ausgelegt ist, um mindestens einen Bereich der optischen Faser (22) zu halten.

9. Sensoranordnung (10) nach einem der vorstehenden Ansprüche, wobei die Aussparung (40) in einer abgeschrägten Fassungsoberfläche (38) eingerichtet ist, die einen Abschrägungswinkel definiert, der der vorbestimmten Winkelposition (a1) entspricht.

10. Sensoranordnung (10) nach dem vorstehenden Anspruch in Kombination mit Anspruch 5, wobei der vordere Abschnitt (56) des Halterungselements eine abgeschrägte Halterungselementoberfläche (62) umfasst, die komplementär zu der abgeschrägten Fassungsoberfläche (38) ist und die mit der abgeschrägten Fassungsoberfläche (38) in Anlage kommt, wenn sich der Stickstoffleerstellendiamant (12) in Position in einem Inneren der Aussparung (40) befindet.

11. Sensoranordnung (10) nach einem der vorstehenden Ansprüche in Kombination mit Anspruch 5, wobei das Trägerelement (30) einen länglichen Abschnitt umfasst, der eine Führungsschiene (66) für das Halterungselement (50) ausbildet, um dem Halterungselement (50) zu ermöglichen, von einer hinteren Position weg von der Fassung (36) in eine vordere Position in Anlage mit der Fassung (36) zu gleiten.

12. Sensoranordnung (10) nach einem der vorstehenden Ansprüche, wobei sie eine obere Abdeckung (68) umfasst, die über der Fassung (36) eingerichtet ist, um den Stickstoffleerstellendiamanten (12) und die optische Faser (22) zu umschließen.

13. Sensoranordnung (10) nach einem der vorstehenden Ansprüche, wobei die Fassung (36) aus einem Stück mit dem Trägerelement (30) hergestellt ist.

14. Sensoranordnung (10) nach einem der vorstehenden Ansprüche, wobei der Stickstoffleerstellendiamant (12) ein monokristalliner flächenzentrierter kubischer Diamant ist, wobei die Schnittfacetten des Stickstoffleerstellendiamanten (12) den {100}-Ebenen derart entsprechen, dass eine Stickstoffleerstellenachse innerhalb des Stickstoffleerstellendiamanten (12) senkrecht zu der Referenzebene (P1) ist, wenn er in der Fassung (36) montiert ist.

15. Magnetometer (74), umfassend eine Sensoranordnung (10) nach einem der vorstehenden Ansprüche.

## Revendications

1. Ensemble capteur (10) comprenant :
- un diamant à centre azote-lacune (12),
- une fibre optique (22) dont l'extrémité avant est connectée à une surface principale supérieure (14) du diamant à centre azote-lacune (12),
- un câble à micro-ondes (24) dont l'extrémité avant est connectée au diamant à centre azote-lacune (12),
- un support de montage (20),
**caractérisé en ce que** le support de montage (20) comprend un élément de support (30) ayant une surface inférieure (32) définissant un plan de référence (P1), et ayant, au niveau d'une extrémité avant, une douille (36) conçu pour recevoir le diamant à centre azote-lacune (12) dans une position angulaire prédéterminée (a1) autour de 54,7 ou 125,3 degrés +/- 5 degrés par rapport au plan de référence (P1) permettant un alignement prédéterminé de son axe azote-lacune par rapport audit plan de référence (P1), ladite douille (36) comprenant un évidement (40) pour loger ledit diamant à centre azote-lacune (12) dans la position angulaire prédéterminée (a1).

2. Ensemble capteur (10) selon la revendication 1, dans lequel l'évidement (40) comprend des surfaces de retenue périphériques (42) pour le diamant qui forment des angles prédéterminés de telle sorte que, lorsque le diamant à centre azote-lacune (12) est reçu dans l'évidement (40), une diagonale (D1) s'étendant d'un coin supérieur du diamant à un coin inférieur du diamant se trouve dans un plan longitudinal (P2) perpendiculaire au plan de référence (P1).

3. Ensemble capteur (10) selon l'une quelconque des revendications précédentes, dans lequel l'évidement (40) comprend une plate-forme extrudée (44) qui forme une surface d'appui (46) pour une surface principale (16) du diamant à centre azote-lacune (12), ladite plate-forme (44) étant surélevée par rapport à une portion fond d'évidement (48).

4. Ensemble capteur (10) selon la revendication précédente, dans lequel la surface d'appui (46) est inclinée, par rapport au plan de référence (P1), d'un angle (a1) d'environ 54,7 ou 125,3 degrés +/- 5 degrés.

5. Ensemble capteur (10) selon l'une quelconque des revendications précédentes, dans lequel le support de montage (20) comprend un élément de maintien (50) sur l'élément de support (30), et qui comprend une surface de guidage (52) pour guider et courber la fibre optique (22) depuis le diamant à centre azote-lacune (12) vers une portion arrière de l'élément de maintien (50), ladite fibre optique (22) ayant une section avant reçue dans l'élément de maintien (50).

6. Ensemble capteur (10) selon la revendication précédente, dans lequel la surface de guidage (52) est agencée sur une portion avant de l'élément de support (50), à proximité de la douille (36), ladite surface de guidage (52) comprenant une rainure (58) présentant un profil en forme d'arc dans un plan longitudinal (P2) perpendiculaire au plan de référence (P1).

7. Ensemble capteur (10) selon la revendication précédente, dans lequel la rainure (58) est conçue de telle sorte qu'une tangente (T1) au profil en forme d'arc au niveau d'une extrémité avant de rainure (60) est perpendiculaire à une surface principale de diamant (14) qui reçoit une extrémité avant de la fibre optique (22).

8. Ensemble capteur (10) selon l'une quelconque des revendications 5 à 7, dans lequel la portion arrière de l'élément de maintien (50) comprend une partie de canal (64) qui s'étend depuis la portion avant (56) jusqu'à une extrémité arrière de l'élément de maintien (50), et qui est conçue pour maintenir au moins une section de la fibre optique (22).

9. Ensemble capteur (10) selon l'une quelconque des revendications précédentes, dans lequel l'évidement (40) est agencé dans une surface inclinée de douille (38) définissant un angle d'inclinaison correspondant à la position angulaire prédéterminée (a1).

10. Ensemble capteur (10) selon la revendication précédente prise en combinaison avec la revendication 5, dans lequel la portion avant d'élément de maintien (56) comprend une surface inclinée d'élément de maintien (62) qui est complémentaire de la surface inclinée (38) de douille et qui vient en butée contre la surface inclinée (38) de douille lorsque le diamant à centre azote-lacune (12) est en position à l'intérieur de l'évidement (40).

11. Ensemble capteur (10) selon l'une quelconque des revendications précédentes prise en combinaison avec la revendication 5, dans lequel l'élément de support (30) comprend une portion allongée formant un rail de guidage (66) pour l'élément de maintien (50) afin de permettre à l'élément de maintien (50) de coulisser d'une position arrière éloignée de la douille (36) à une position avant en butée contre la douille (36).

12. Ensemble capteur (10) selon l'une quelconque des revendications précédentes, dans lequel il comprend un couvercle supérieur (68) qui est agencé au-dessus de la douille (36) pour renfermer le diamant à centre azote-lacune (12) et la fibre optique (22).

13. Ensemble capteur (10) selon l'une quelconque des revendications précédentes, dans lequel la douille (36) est réalisée en une seule pièce avec l'élément de support (30).

14. Ensemble capteur (10) selon l'une quelconque des revendications précédentes, dans lequel le diamant à centre azote-lacune (12) est un diamant cubique à faces centrées monocristallin, les facettes taillées du diamant à centre azote-lacune (12) correspondant aux plans {100} de telle sorte qu'un axe azote-lacune à l'intérieur du diamant à centre azote-lacune (12) est perpendiculaire au plan de référence (P1) lorsqu'il est monté dans la douille (36).

15. Magnétomètre (74) comprenant un ensemble capteur (10) selon l'une quelconque des revendications précédentes.
